(19) Europäisches Patentamt
European Patent Office
Office européen des brevets

(11) **EP 4 653 953 A1**

(12) **EUROPEAN PATENT APPLICATION**

(43) Date of publication:
**26.11.2025 Bulletin 2025/48**

(21) Application number: **24177237.5**

(22) Date of filing: **22.05.2024**

(51) International Patent Classification (IPC):
**G03F 7/00** $^{(2006.01)}$   **G06Q 10/20** $^{(2023.01)}$

(52) Cooperative Patent Classification (CPC):
**G03F 7/70975; G03F 7/70533; G03F 7/70633;
G03F 7/707; G06Q 10/04; G06Q 10/20;
G06Q 50/04**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventor: **AARDEN, Frans, Bernard
5500 AH Veldhoven (NL)**

(74) Representative: **ASML Netherlands B.V.
Corporate Intellectual Property
P.O. Box 324
5500 AH Veldhoven (NL)**

Remarks:
Claims 16 to 25 are deemed to be abandoned due to
non-payment of the claims fee (Rule 45(3) EPC).

(54) **METHOD OF PREDICTING AN ON PRODUCT EFFECT OF A WAFER LOAD GRID**

(57) Disclosed is a method of predicting an on-product parameter of interest data component attributable to physical interaction between a substrate and a substrate support. The method comprises obtaining inline on-product data relating to a measurement of said substrate; removing non-relevant components of said inline on-product data from said inline on-product data to obtain processed inline on-product data, said non-relevant components comprising components of said inline on-product data not attributable to the wafer load grid and/or which are correctable; determining at least one performance indicator describing a variation of the processed inline on-product data; and applying at least one scaling factor to said at least one performance indicator to obtain said on-product parameter of interest data component; the at least one scaling factor having been determined from a characteristic onsubstrate wear pattern being representative for said physical interaction between substrate and substrate support.

Fig. 4

EP 4 653 953 A1

**Description**

BACKGROUND

The present invention relates to methods and apparatus usable, for example, in the manufacture of devices by lithographic techniques, and to methods of manufacturing devices using lithographic techniques.

FIELD OF THE INVENTION

A lithographic apparatus or exposure apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

It is necessary to routinely perform maintenance actions on a lithographic so as to replace deteriorated components. In particular, the wafer table (substrate support) requires periodic replacement due to wear on the wafer table burls (protrusions) which actually support the substrate. It may be necessary to ramp-down (temporarily cease production) of one or more layers in the run-up to a maintenance action, as the fingerprints or impact of the replacement component compared to replaced component can cause large overlay errors when different layers of the same substrate have been exposed before and after the maintenance action.

It is desirable to determine when such maintenance actions should be performed.

SUMMARY OF THE INVENTION

The invention in a first aspect provides a method of predicting an on-product parameter of interest data component attributable to physical interaction between a substrate and a substrate support, the method comprising: obtaining inline on-product data relating to a measurement of said substrate; removing non-relevant components of said inline on-product data from said inline on-product data to obtain processed inline on-product data, said non-relevant components comprising components of said inline on-product data which are not attributable to the physical interaction between the substrate and the substrate support and/or which are correctable in a process control strategy; determining at least one performance indicator describing a variation of the processed inline on-product data; and applying at least one scaling factor to said at least one performance indicator to obtain said on-product parameter of interest data component; the at least one scaling factor having been determined from a characteristic on-substrate wear pattern being representative for said physical interaction between substrate and substrate support.

Also disclosed is a computer program and lithographic apparatus being operable to perform the method of the first aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3(a) conceptually illustrates the cancelling effect in overlay of wafer table fingerprints in each layer in the absence of a wafer table swap, and Figure 3(b) conceptually illustrates the performance impact in overlay of such a wafer table swap; and
Figure 4 is a flowchart describing a method for estimating an on-product impact attributable to a wafer load grid.

DETAILED DESCRIPTION OF EMBODIMENTS

Before describing embodiments of the invention in detail, it is instructive to present an example environment in which embodiments of the present invention may be implemented.

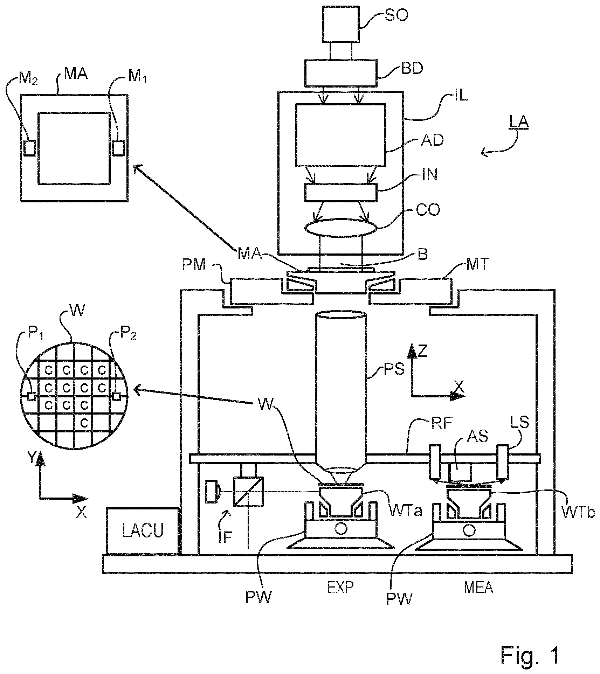

Figure 1 schematically depicts a lithographic apparatus LA (or more generally an exposure apparatus). The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

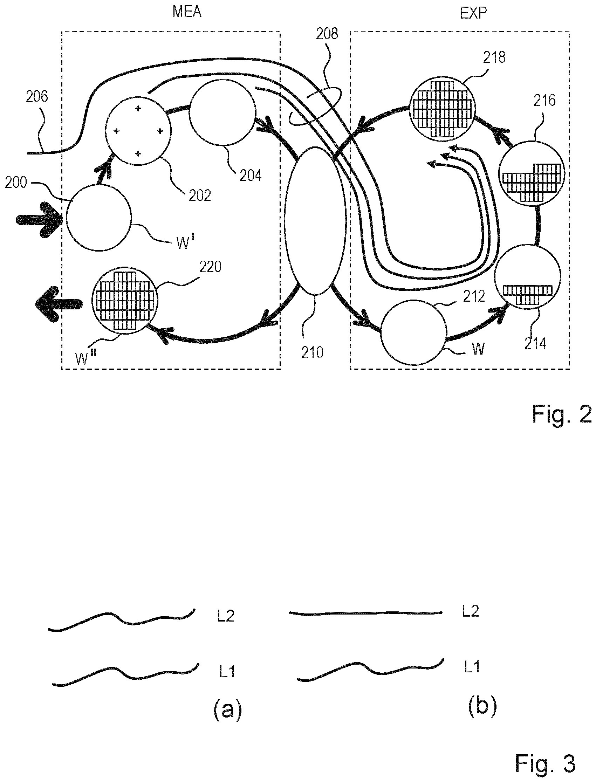

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

A lithographic apparatus or scanner requires regular maintenance actions, for example to replace hardware components which are subject to degradation over time. By way of a specific example, the wafer table of a scanner degrades and requires periodic replacement. Such hardware swaps and/or maintenance actions, can result in a performance impact.

Such a performance impact is conceptually illustrated in Figure 3. Overlay is an important parameter which describes the proper placement of a layer with respect to a previously exposed (lower) layer. Each wafer table imposes a wafer clamping impact or clamping fingerprint on a substrate clamped thereto, which should be corrected for. However, as a wafer table wears over time, the associated wafer clamping impact is affected (typically becoming greater) which will affect the positioning of exposed structures on the substrate. As such, the degradation of the wafer table (and other components) will lead to positional errors; these errors can be divided into lower frequency errors or correctable errors (CEs), which may be measured (using a suitable metrology tool) and corrected for within the scanner via a process correction loop (e.g., as known as the advanced process corrections or APC loop), and higher frequency errors or non-correctable errors (NCEs) which cannot be corrected via APC either because the effect of the errors cannot be measured using sufficiently fast metrology, captured by the models used to represent the metrology data and/or because the required corrections cannot be actuated within the scanner.

Without a wafer table swap, the wafer clamping impact changes sufficiently slowly such that there is essentially no significant change between exposures of different layers on a single wafer. Because overlay is a relative measure between two layers, NCEs resulting from this impact in each layer largely cancel themselves out. Referring to Figure 3(a), the lines for the first layer L1 and second layer L2 represent a high frequency component of wafer grid impact of a degraded wafer table. Although this degradation results in a relatively large magnitude disturbance of the local placement of features in each exposure layer, these disturbances are typically sufficiently similar in each layer and cancel themselves out in overlay (i.e., the positional errors are the same in each layer meaning that misalignment between layers due to this effect is relatively small). Therefore, overlay NCEs due to this wafer table fingerprint in each layer will be small. By contrast, Figure 3(b) conceptually illustrates the situation should there be a wafer table swap between exposure of layer L1 and L2. The new table results in an overall smaller wafer grid impact due to wafer table imperfection; however the impact of the old table is present in the layer L1 exposure. Therefore, there is no longer a cancelling out of this impact, resulting in a significantly larger NCE overlay penalty. This may cause an APC non-correctable jump due to the difference in these fingerprints, which may be sufficiently large to affect yield (the fact that the errors are non-correctable means that these wafers cannot be recovered via rework).

This overlay penalty due to hardware maintenance during wafer processing (i.e., between exposing different layers on a wafer) is often referred to as a wafer-in-process (WIP) impact. One strategy to mitigate this WIP impact, is to "ramp-down" the exposure of a number of layers in the run-up to such a maintenance action, so as to reduce the number of wafers in progress (wafers with only some of the required layers exposed) at the time of the action. Such a ramp-down typically comprises the ceasing of exposure of one or more layers in the weeks leading up to the maintenance action, e.g., ceasing exposure of each layer in turn from the bottom layer, at intervals of a few days to a couple or few weeks between the ramping down of each successive layer. It may be that not all layers are ramped down. This ramping down of layers represents a loss of productivity with respect to continuing wafer production at the rate prior to beginning ramp-down.

In addition to a ramp-down impact, there will be an accompanying ramp-up impact (i.e., in comparison to full production rate) when production restarts following the maintenance action. For example, there is a need to restart production for each layer ramped down layer before production of layers higher in the stack can be started.

The wafer table reconditioning/swap will also cause a sudden change in CE. APC has the potential to correct for this sudden change, but it is too slow as there is no (or insufficient) metrology data for the post-maintenance system, at least for an initial number of lots. To address this, the correction loop or APC loop may be restarted and/or recalibrated, which takes time and therefore results in a production delay. As an alternative, production may be continued without such a recalibration; however, this typically results in exposures that are out-of-specification. As such, many of the first wafers in progress that are exposed post-maintenance action will be exposed out-of-spec and therefore will require reworking (stripped of the poorly exposed resist, re-covered and re-exposed).

Wafer load grid (WLG) is a wafer distortion, typically described in terms of a distortion in overlay, related to unflatness of the substrate (wafer) during clamping and finite friction coefficient between burls and substrate. As such, WLG may describe the wafer distortion resultant from a physical interaction between the wafer (substrate) and wafer table (substrate support). Burls are projections on the substrate support (wafer table) on which the substrate is supported. A perfect loading of a substrate onto a substrate support implies that no strain remains in the loaded substrate once it fully lies on (and is clamped to) the plurality of burls. Any strain locked into the substrate may deform the substrate in the XY plane and thereby cause overlay errors. Local sliding of the substrate may take place when loading the substrate onto the substrate support. The residual deformations in the substrate caused by this local sliding contributes to the overlay error.

Wafer clamping may comprise a sequence of wafer loading from e-pins to the substrate holder or wafer table. Such a process may comprise carrying the substrate on the e-pins downward to the substrate table, when the substrate contacts the substrate holder, it is clamped on the substrate holder (e.g., by vacuum or electrostatically depending on the scanner type) such that stresses are locked into the substrate.

The physical properties of a wafer depend on the product and layer. The WLG causes an average-wafer deformation typically comprising a donut shape. This average-wafer deformation is mainly a correctable error (CE), which is corrected partly via alignment corrections (e.g., higher-order alignment modeling). The residual CE after alignment correction is addressed through process corrections such as the aforementioned APC control loop. WLG also causes a wafer-to-wafer deformation that is not correctable by any correction mechanism, i.e., this represents a non-correctable error (NCE). As the wafer table condition worsens over time, the NCE increases until the resultant on-product overlay (OPO) error becomes too large, with a resultant impact on yield. The NCE contribution is caused by wafer-to-wafer deformation which is high frequent. After loading of a wafer, this deformation varies from wafer to wafer (and lot to lot).

To prevent yield loss, a maintenance action may be periodically performed to replace or recondition the wafer table. The wafer table swap will have a consequent WIP impact because the process corrections will not match the re-conditioned wafer table. Either the process corrections are reset and re-calibrated or the process corrections are automatically recovered. Reset and recalibration of the process corrections leads to significant down time (on the order of days or weeks) and a significant related human effort. Automatically recovering the process corrections causes the initial lots to suffer from OPO errors and typically requires them to be reworked until the OPO is within specification.

Disclosed herein is a method of determining an on-product parameter of interest data component attributable to physical interaction between a substrate and a substrate support, such as on product overlay (OPO) data component or contribution specifically attributable to the WLG. More specifically, the method may comprise determining such an OPO contribution attributable to an NCE component of the WLG. The method may comprise determining at least one performance indicator; e.g., a key performance indicator or KPI which provides an unscaled OPO contribution attributable to the WLG. This unscaled OPO contribution may then be scaled using a (e.g., pre-calculated) scaling factor relating to a specific alignment strategy (or e.g., a modelling and/or measurement/layout strategy) and/or wafer table hardware configuration used. A first (wafer-to-wafer or substrate-to-substrate) KPI and a second (lot-to-lot) KPI may be determined.

The OPO contribution determined using such a method may be used to determine the impact of a wafer table swap at that time. This, in turn, may be used to determine a good or optimal moment for performing a maintenance action, e.g., to swap or recondition the wafer table. Such a good or optimal moment may be one which has minimal impact on yield and/or throughput; or to find a good or optimal best balance between yield and throughput.

The WLG (e.g., more specifically the NCE) contribution of OPO is typically spatially and temporally (i.e., wafer-to-wafer) highly frequent. Because of this, its on-wafer error vectors have Gaussian-like behavior and are indistinguishable from other error sources.

Present methods for measuring the WLG contribution of OPO may comprise using dedicated wafers for determining the WLG state of the wafer table. Such dedicated tool wafers may comprise WLG-sensitive and WLG-insensitive wafers, e.g., with predefined alignment mark positions. The difference in measurements of the WLG-sensitive (e.g., conventional and/or smooth backside wafers) and WLG insensitive wafers (e.g., rough backside wafers) enable the WLG contribution to be isolated. Such an approach does not give a reliable value for the WLG OPO contribution, because this is determined by the wafer (backside) properties of the two relevant layers (i.e., the two layers between which overlay is being determined) and of the wafer table state at the moment of exposure for both layers. However, there can be a significant time period (e.g., anything on the order of between days to months) between exposure of these two layers.

Other methods may comprise directly measuring the combined error sources using an overlay metrology tool (e.g., a scatterometer) or measuring the combined error sources with e.g., RPN (residual process noise related to wafer-to-wafer fine wafer alignment FIWA). However, neither of these approaches is able to isolate the WLG OPO contribution from those of other error sources.

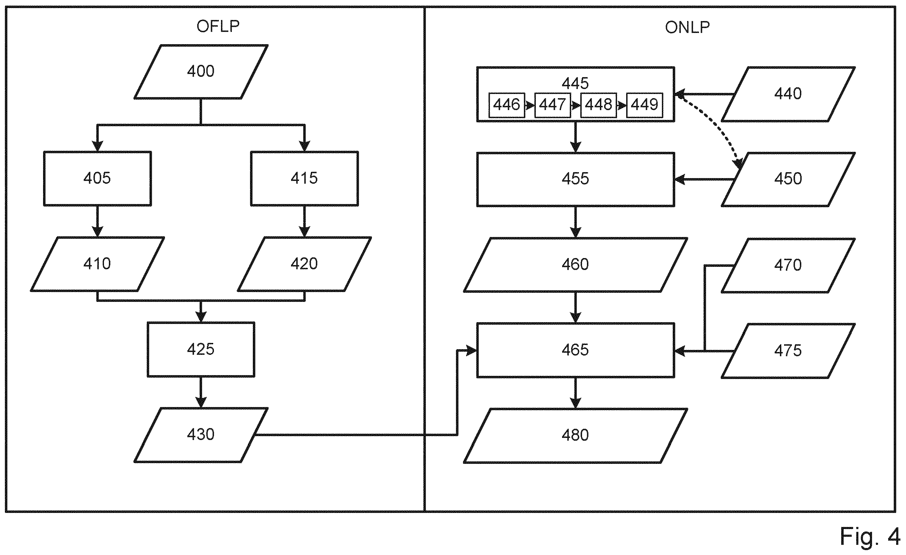

Figure 4 is a flowchart describing a method for estimating an on-product (e.g., OPO) impact attributable to the WLG (e.g., the NPE component of the OPO attributable to the WLG). The method comprises an online phase ONLP and an offline phase OFLP.

In the online phase ONLP, input inline on-product data 440, such as alignment data (e.g., fine wafer alignment data FIWA) is obtained and used to model intermediate KPIs in a first online modeling step 445.

The first online modeling step 445 may comprise a number of sub-steps 446-449 to remove non-relevant components from the input inline on-product data 440 and determining one or more intermediate KPIs. Such non-relevant components may comprise components or contributors to OPO which are not a result of WLG or wafer clamping and/or which are correctable (e.g., via APC and/or alignment).

At sub-step 446 a correctable error component may be removed, e.g., an error component as modeled by linear alignment model terms; i.e., modeled by a 6-parameter linear alignment model which models the alignment data in terms of translation, magnification and rotation errors, and grid residuals, in X and Y.

At sub-step 447, known large non-WLG shapes (e.g., known thermal deformation induced shapes/components) may also be removed from the alignment data. Such thermally induced shapes may be responsible for more than half of the inline on-product data variation.

Sub-step 448 comprises calculating wafer-to-wafer error data to determine a first or wafer-to-wafer intermediate KPI and/or a lot-to-lot error data to determine a second or lot-to-lot intermediate KPI. Wafer-to-wafer error data may comprise measured error values (e.g., described by the inline alignment data 440) for each wafer, from which a mean error is removed, the mean error comprising the mean of the measured error values over the lot in which the wafer is comprised. This per-lot mean error should be determined per-chuck when the lithographic apparatus comprises two or more chucks. The lot-to-lot error data may comprise mean_lot-to-mean_lot error values; i.e., which describes the mean wafer of the current lot from which the mean wafer over a previous N lots has been removed, where N is an integer (e.g., where N is between 5 and 30, between 5 and 20 or between 5 and 15). Both of these wafer-to-wafer and lot-to-lot errors contribute to the NCE variation (i.e., they are not correctable by APC).

All (significant) variation contributors are comprised within the on-product (alignment) data 440, and therefore will be represented by the KPIs, so as to obtain a WLG-specific OPO representative KPI without using OPO data.

Optional sub-step 449 comprises using only error data relating to an inner region of each wafer to determine the KPIs (i.e., discarding error data relating to peripheral/edge regions). The WLG variation is typically larger for the inner region of the wafers, while errors at the edge region tend to not result from the WLG. As such, using only inner region data may make the KPIs more WLG specific.

At second online modeling step 455, historical data 450 of both the wafer-to-wafer KPI and the lot-to-lot KPI may be used to make the KPIs further WLG specific. This step may comprise subtracting a respective offset from each KPI which is attributable to the process, rather than the WLG. These offsets may be product and/or layer dependent, for example. The offsets can be determined, for example, by observing the historical wafer-to-wafer and lot-to-lot data from time frames where WLG does not make significant contribution. For example, the offsets may be determined during a time period where the WLG is stable (e.g., immediately or soon after a wafer table swap). Other methods to determine the offsets may use data from the aforementioned WLG-insensitive wafers to measure this offset, or as a reference for identifying time frames where WLG does not make significant contribution. Alternatively, prior information (e.g., with or without machine learning) may be used to identify these time frames. The offsets are typically stable over a long period of time (e.g., on the order of weeks or months) and therefore may be used for future KPI determinations once determined.

Each offset may be subtracted quadratically from its respective intermediate KPI because each offset represents process errors that are expressed in standard deviations of a near-Gaussian distribution.

All components removed in the steps above (e.g., as removed at sub-steps 446 (correctable errors), 447 (non-WLG shapes), 449 (wafer periphery data) and at step 455 (offsets) are all examples of non-relevant components within the context of this disclosure. The resultant inline on-product data subsequent to any one or more of these steps comprises processed inline on-product data within the context of this disclosure.

As an alternative to at least sub-step 446, and optionally as an alternative to sub-steps 446, 447 and 449, step 445 may comprise removing components described by an alignment model and/or correction strategy used in exposing a bottom layer on the the wafer, the bottom layer being the lower of the two layers between which the OPO component relates. This approach may be more accurate if the alignment model and/or correction strategy used in exposing the bottom layer on the wafer has a significantly larger order of correction potential than the aforementioned linear model that is based on non-relevant known components.

The resultant unscaled KPIs 460, i.e., unscaled first or wafer-to-wafer KPI and unscaled second or lot-to-lot KPI, may be scaled 465 using a respective scaling factor 430 (e.g., a single scaling factor for the two KPIs or a respective scaling factor for each KPI), to obtain the WLG resultant contribution of the OPO 480. To select an appropriate scaling factor (or pair of scaling factors), scaling step 465 may use inline correction strategy data 470 (e.g., the correction or alignment strategy to be applied to the present wafer), as the scaling factors are determined per correction strategy (as will be described). Optionally, the scaling factors may also be determined per hardware configuration/setting (e.g., wafer clamping flow settings, wafer table types and wafer shapes), and therefore such hardware configuration/setting data 475 may be used in to determine the appropriate scaling factor(s) in the scaling step 465.

The unscaled KPIs do not properly represent the OPO effect because the correction/alignment method has not been taken into account. Simply applying the used alignment method does not give an accurate estimate because of the limited amount of alignment marks compared to the number of wafer alignment model parameters. The methods described herein instead apply at least one scaling factor which can be obtained without OPO data (which is not always readily available).

Essentially, the unscaled (on-product inline) KPIs describe an on-product metric which is not readily interpretable because, while it is related to overlay, it does not actually describe overlay (which is the readily understood metric). The application of the scaling factor translates the on-product metric of the KPIs to OPO.

The KPIs may be expected to be close enough to the target OPO such that a linear scaling factor (e.g., referred to as k1) may be sufficient for conversion. For example, linear scaling factor may be applied to the quadratic sum of the lot-to-lot KPI $KPI_{L2L}$ and wafer-to-wafer KPI $KPI_{W2W}$ to obtain the desired on-product overlay resultant from the WLG $WLG_{OPO}$:

$$WLG_{OPO} = k1 * \sqrt{(KPI^2_{L2L} + KPI^2_{W2W})}$$

The lot-to-lot KPI $KPI_{L2L}$ and wafer-to-wafer KPI $KPI_{W2W}$ are summed up quadratically because NCE variation errors, expressed in standard deviations, have a close to Gaussian distribution. The scaling factor depends on alignment strategy and wafer table configurations. As has been stated, separate scaling factors per KPI may instead be determined and applied.

The WLG resultant contribution of the OPO 480 can then be used to make a maintenance decision, e.g., as to whether to recondition and/or swap a wafer table.

The offline phase OFLP may comprise determining the scaling factors for each of the relevant correction strategies and optionally each relevant hardware configuration/setting. All steps 400-425 may be performed per hardware configuration. Per hardware configuration, steps 405-425 may be performed per correction strategy.

The offline phase OFLP may comprise obtaining the characteristic on-wafer wear pattern 400 relating to a particular lithographic apparatus module or chuck. A characteristic on-wafer wear pattern 400 may be obtained per hardware configuration as has been described, as this wear pattern may be different for different wafer table types, flow settings and wafer shapes (e.g., bowl vs umbrella).

The characteristic on-wafer wear pattern 400 may be determined using the aforementioned WLG-sensitive and WLG-non-sensitive wafers having predefined alignment mark positions. Measurements of these wafers on a worn wafer table makes it possible to isolate the WLG characteristic wear pattern.

The characteristic on-wafer wear pattern for the wafer-to-wafer KPI may be taken from the wafer-to-wafer variation of at least two WLG-sensitive wafers of the same ingot. The characteristic on-wafer wear pattern for the lot-to-lot KPI may be taken from the mean-wafer to mean-wafer variation of wafers from at least two different ingots. This is motivated by knowledge that wafers from different ingots are physically more different than wafers from the same ingot, and a single lot typically comprises wafers from a single ingot while different lots typically comprise wafers from different ingots.

At step 405, the KPI model may be applied to the characteristic on-wafer wear pattern 400 in a similar manner to at least step 445. An equivalent step to step 455 may also be performed using information from the non-sensitive wafers, although this will have little effect and may be ignored in this offline phase, as the wear pattern already stems from a measurement that fully isolates the WLG error from other sources. The result of this step will be representative wafer-to-wafer and lot-to-lot KPIs 410 which are representative of the inline KPIs for one or more specific wear patterns.

Step 415 comprises applying representative alignment strategies to the characteristic on-wafer wear pattern data 400 and calculating the resultant representative residuals or representative parameter of interest data or representative overlay data 420. The representative overlay data is representative of OPO in the inline case, but is not of course actually on-product (it is derived from non-product data). Different representative alignment strategies applied may relate to different modeling strategies (e.g., polynomial models versus radial basis function models) different orders for polynomial models (e.g., 3rd order vs 5th order) and/or different sampling schemes/alignment mark layouts. Because of the vast number of possible sampling schemes, OPO may be calculated for only different numbers of marks measured (e.g., randomly distributed over the wafer), rather than for each possible sampling scheme (although performing this step 415 for all or some specific sampling schemes is also possible).

Step 425 comprises determining the scaling factor(s) per alignment strategy (and optionally per hardware configuration) from the representative KPIs 410 and calculated representative overlay 420. Assuming a linear scaling factor k1, this may be calculated using the equation for $WLG_{OPO}$ above, where ($WLG_{OPO}$ is the representative overlay 420 and $KPI_{L2L}$, $KPI_{W2W}$ are the representative KPIs 410).

The result of this phase is a set of scaling factors 430 for different correction strategies and for one or more different hardware settings.

The methods herein may be implemented as software. For example, the method described by the algorithm depicted in Figure 4 may be implemented as a software program or respective separate software programs for each of the online phase and offline phase.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of predicting an on-product parameter of interest data component attributable to physical interaction between a substrate and a substrate support, the method comprising:

   obtaining inline on-product data relating to a measurement of said substrate;
   removing non-relevant components of said inline on-product data from said inline on-product data to obtain processed inline on-product data, said non-relevant components comprising components of said inline on-product data which are not attributable to the physical interaction between the substrate and the substrate support and/or which are correctable in a process control strategy;
   determining at least one performance indicator describing a variation of the processed inline on-product data; and
   applying at least one scaling factor to said at least one performance indicator to obtain said on-product parameter of interest data component, the at least one scaling factor having been determined from a characteristic on-substrate wear pattern being representative for said physical interaction between substrate and substrate support.

2. A method as claimed in claim 1, wherein said determining at least one performance indicator comprises determining at least a first performance indicator describing a substrate-to-substrate variation of the processed inline on-product data.

3. A method as claimed in claim 1 or 2, wherein said determining at least one performance indicator comprises determining at least a second performance indicator describing a lot-to-lot variation of the processed inline on-product data.

4. A method as claimed in any preceding claim, wherein said step of removing non-relevant components further comprises removing a respective offset from each said at least one performance indicator, the offset relating to a time period where said physical interaction between a substrate and a substrate support does not make a significant contribution to said on-product data.

5. A method as claimed in claim 4, wherein each said offset is determined from respective historical performance indicator data for the corresponding performance indicator.

6. A method as claimed in any preceding claim, wherein said non-relevant components of said inline on-product data comprise components describable by a linear model.

7. A method as claimed in claim 6, wherein said linear model comprises translation, rotation and magnification parameters.

8. A method as claimed in claim 1 to 5, wherein said non-relevant components of said inline on-product data comprise components described by an alignment model and/or correction strategy used in exposing a bottom layer on said substrate, the bottom layer being the lower of the two layers between which the on-product parameter of interest data component relates.

9. A method as claimed in any preceding claim, wherein said non-relevant components comprise known components not attributable to physical interaction between a substrate and a substrate support.

10. A method as claimed in claim 9, wherein said known components not attributable to physical interaction between a substrate and a substrate support comprise at least components resulting from thermal deformation of the substrate.

11. A method as claimed in any preceding claim, wherein said step of removing non-relevant components comprises removing said on-product data relating to a peripheral region of the substrate.

12. A method as claimed in any preceding claim, comprising selecting said at least one scaling factor from a set of scaling factors depending on one or both of a correction strategy used in exposing said substrate and/or a hardware configuration used when exposing said substrate.

13. A method as claimed in claim 12, wherein said correction strategy relates to one or more of: a model fitted to the on-product data, a number of measurement locations measured to obtain the on-product data and/or the arrangement of the measurement locations measured to obtain the on-product data.

**14.** A method as claimed in claim 12 or 13, wherein said hardware configuration comprises one or more of: a substrate clamping flow setting, a wafer table type and/or a wafer shape.

**15.** A method as claimed in any preceding claim, comprising an initial step to determine said at least one scaling factor for each of a plurality of different correction strategies and/or hardware configurations.

**16.** A method as claimed in claim 15, wherein said initial step comprises the step of:

determining a characteristic on-substrate wear pattern for each of at least one hardware configuration;
determining at least one representative performance indicator for each said characteristic on-substrate wear pattern, each at least one representative performance indicator corresponding to a respective said at least one performance indicator;
determining a corresponding representative parameter of interest data for each said representative performance indicator, for each of a plurality of different correction strategies; and
determining a scaling factor to relate each said at least one representative performance indicator to a corresponding said representative parameter of interest data.

**17.** A method as claimed in any preceding claim, wherein said at least one scaling factor comprises at least one linear scaling factor.

**18.** A method as claimed in any preceding claim, wherein said inline on-product data comprises alignment data.

**19.** A method as claimed in any preceding claim, wherein said on-product parameter of interest data component comprises an on-product overlay data component.

**20.** A method as claimed any preceding claim, comprising deciding to perform and/or scheduling a maintenance action based on the on-product parameter of interest data component.

**21.** At least one computer program comprising program instructions operable to perform the method of any of claims 1 to 20, when run on a suitable apparatus.

**22.** A non-transient computer program carrier comprising the at least one computer program of claim 21.

**23.** A processing system comprising a processor and a storage device comprising the at least one computer program of claim 21.

**24.** An exposure apparatus comprising the processing system of claim 23.

**25.** An exposure apparatus as claimed in claim 24, further comprising:

a patterning device support for supporting a patterning device;
projection optics for projecting a pattern onto the patterning device; and
a substrate support for supporting a substrate.

Fig. 1

MEA

EXP

206

208

218

216

200

202

204

220

W'

210

212

214

W

W''

Fig. 2

L2

L2

L1

L1

(a)

(b)

Fig. 3

Fig. 4

## EUROPEAN SEARCH REPORT

**Application Number**

EP 24 17 7237

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 279 992 A1 (ASML NETHERLANDS BV [NL]) 22 November 2023 (2023-11-22) * paragraphs [0005], [0006], [0036] - [0039], [0047], [0056] - [0059]; figures 3, 7 * | 1-15 | INV. G03F7/00 G06Q10/20 |
| A | "METHOD OF MONITORING AN EXPOSURE PROCESS", RESEARCH DISCLOSURE, KENNETH MASON PUBLICATIONS, HAMPSHIRE, UK, GB , vol. 720, no. 10 28 February 2024 (2024-02-28), XP007152423, ISSN: 0374-4353 Retrieved from the Internet: URL:https://www.researchdisclosure.com/dat abase/RD720010 [retrieved on 2024-02-28] * the whole document * | 1-15 | |
| A | US 2021/117931 A1 (ABE KUNIHIKO [JP] ET AL) 22 April 2021 (2021-04-22) * the whole document * | 1-15 | TECHNICAL FIELDS SEARCHED (IPC) G03F G06Q |

The present search report has been drawn up for all claims

| Place of search | Date of completion of the search | Examiner |
|---|---|---|
| Munich | 10 February 2025 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 7237

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2025

| Patent document cited in search report | | Publication date | Patent family member(s) | | Publication date |
|---|---|---|---|---|---|
| EP 4279992 | A1 | 22-11-2023 | NONE | | |
| US 2021117931 | A1 | 22-04-2021 | CN | 112384859 A | 19-02-2021 |
| | | | JP | 7258028 B2 | 14-04-2023 |
| | | | JP | WO2020031301 A1 | 02-08-2021 |
| | | | US | 2021117931 A1 | 22-04-2021 |
| | | | WO | 2020031301 A1 | 13-02-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1